# EUROPEAN PATENT SPECIFICATION

(11) **EP 2 136 387 B1**
(45) Date of publication and mention of the grant of the patent: **19.09.2012**
(21) Application number: 09717696.0
(22) Date of filing: 25.02.2009
(51) Int. Cl.: H01J 11/12, H01J 11/40, H05K 7/20

(54) **PLASMA DISPLAY DEVICE**
PLASMAANZEIGEVORRICHTUNG
DISPOSITIF D'AFFICHAGE À PLASMA

(30) Priority: 06.03.2008 JP 2008056103
(43) Date of publication of application: 23.12.2009
(73) Proprietor: Panasonic Corporation, Kadoma-shi Osaka 571-8501 (JP)
(72) Inventor: MIZOKAMI, Kaname, Osaka-shi, Osaka 540-6207 (JP); ISHINO, Shinichiro, Osaka-shi, Osaka 540-6207 (JP); SAKAMOTO, Koyo, Osaka-shi, Osaka 540-6207 (JP); MIYAMAE, Yuichiro, Osaka-shi, Osaka 540-6207 (JP); OOE, Yoshinao, Osaka-shi, Osaka 540-6207 (JP); KAWARAZAKI, Hideji, Osaka-shi, Osaka 540-6207 (JP)
(74) Representative: Kügele, Bernhard
(86) International application number: PCT/JP2009/000825
(87) International publication number: WO 2009/110196

(56) References cited:
- EP-A1- 2 031 629
- EP-A1- 2 099 049
- EP-A1- 2 099 051
- EP-A1- 2 099 052
- EP-A1- 2 101 342
- EP-A2- 1 657 735
- EP-A2- 1 659 605
- EP-A2- 1 883 092
- WO-A1-2007/102329
- WO-A1-2007/102329
- WO-A1-2007/126061
- WO-A1-2007/139183
- JP-A- 2003 295 786
- JP-A- 2003 295 786
- JP-A- 2005 250 485
- JP-A- 2006 147 417
- JP-A- 2006 244 784
- JP-A- 2007 035 655
- JP-A- 2007 280 730
- JP-A- 2007 311 075
- JP-A- 2008 293 772
- US-A1- 2005 194 900
- US-A1- 2008 049 382
- US-B1- 6 753 649

## Description

### TECHNICAL FIELD

The present invention relates to a plasma display device using a plasma display panel as a display device. The document WO-A-2003 139 183 discloses a plasma display panel reflecting the preamble of present claim 1.

### BACKGROUND ART

Since a plasma display panel (hereinafter, referred to as a "PDP") can realize high definition and a large screen, 65-inch class televisions are commercialized. Recently, PDPs have been applied to high-definition television in which the number of scan lines is twice or more than that of a conventional NTSC method. Meanwhile, from the viewpoint of environmental problems, PDPs without containing a lead component have been demanded.

A PDP basically includes a front panel and a rear panel. The front panel includes a glass substrate of sodium borosilicate glass produced by a float process, display electrodes each composed of stripe-shaped transparent electrode and bus electrode formed on one principal surface of the glass substrate, a dielectric layer covering the display electrodes and functioning as a capacitor, and a protective layer made of magnesium oxide (MgO) formed on the dielectric layer. The rear panel includes a glass substrate, stripe-shaped data electrodes formed on one principal surface of the glass substrate, a base dielectric layer covering the data electrodes, barrier ribs formed on the base dielectric layer, and phosphor layers formed between the barrier ribs and emitting red, green and blue light, respectively.

Furthermore, a plasma display device using this PDP is produced as follows. The PDP is held at the front surface side of a chassis member made of a metal plate, and a drive circuit block for driving the PDP is disposed at the rear surface side of the chassis member, thus configuring a PDP module. This PDP module is accommodated in a case (see Patent document 1).

Recently, televisions have achieved higher definition. In the market, high-definition (1920 x 1080 pixels: progressive display) PDPs with a low cost, low power consumption and high brightness have been demanded.
[Patent document 1] Japanese Patent Unexamined Publication No. 2007-121829

Further out is disclosed by the document -A- 2007 126 061, US - A - 2008 049382, and E P -A- 1657 735.

### SUMMARY OF THE INVENTION

A plasma display device of the present invention is disclosed in claim 1.

With such a configuration, performance of a PDP having excellent electron emission performance and high electric charge retention performance can be exhibited sufficiently. Thereby, it is possible to realize a plasma display device having high-definition and high-brightness display performance with low electric power consumption at low cost.

### BRIEF DESCRIPTION OF THE DRAWINGS

Fig. 1 is a perspective view showing a structure of a PDP used in a plasma display device in accordance with an exemplary embodiment of the present invention.
Fig. 2 shows an arrangement of electrodes of the PDP.
Fig. 3 is a block circuit diagram showing a plasma display device in accordance with an exemplary embodiment of the present invention.
Fig. 4 is a drive voltage waveform diagram of the device.
Fig. 5 is an exploded perspective view showing an entire configuration of the plasma display device in accordance with an exemplary embodiment of the present invention.
Fig. 6 is a plan view showing a PDP module portion of the device seen from the rear surface side.
Fig. 7A is a plan view showing a PDP of the PDP module seen from the rear surface side.
Fig. 7B is a plan view showing a PDP of the PDP module seen from the front surface side.
Fig. 8 is an enlarged plan view showing a principle portion of the PDP module.
Fig. 9 is a sectional view showing a configuration of a front panel of a PDP in a plasma display device in accordance with an exemplary embodiment of the present invention.
Fig. 10 is an enlarged view illustrating an aggregated particle in a protective layer of the PDP.
Fig. 11 is a graph showing an investigation result of electron emission performance and a Vscn lighting voltage in a PDP in the results of experiment carried out for illustrating the effect by the exemplary embodiment of the present invention.
Fig. 12 is a graph showing a measurement result of cathode luminescence of a crystal particle.
Fig. 13 is a graph showing a relation between a particle diameter of a crystal particle and electron emission performance.
Fig. 14 is a graph showing a relation between a particle diameter of a crystal particle and the occurrence rate of damage of a barrier rib.
Fig. 15 is a graph showing an example of particle size distribution of crystal particles in a PDP in accordance with an exemplary embodiment of the present invention.

### REFERENCE MARKS IN THE DRAWINGS

- 1: front panel
- 2: rear panel
- 3: discharge space
- 4: scan electrode
- 5: sustain electrode
- 6: display electrode
- 7: black stripe (light blocking layer)
- 8: dielectric layer
- 81: first dielectric layer
- 82: second dielectric layer
- 9: protective layer
- 10: data electrode
- 11: base dielectric layer
- 12: barrier rib
- 13: phosphor layer
- 14: plasma display panel (PDP)
- 14a, 14b, 14c: electrode terminal portion
- 16: data electrode drive circuit
- 17: scan electrode drive circuit
- 18: sustain electrode drive circuit
- 20: chassis member
- 25, 28: flexible wiring board
- 26, 27, 30: drive circuit board
- 29: data driver
- 91: base film
- 92: particle, each particle (92) being formed by aggregated crystal particles (92a) made of metal oxide.
- 92a: crystal particle

### DETAILED DESCRIPTION OF THE PREFERRED EMBODIMENT

Hereinafter, a plasma display device in accordance with an exemplary embodiment of the present invention is described with reference to drawings.

### (EXEMPLARY EMBODIMENT)

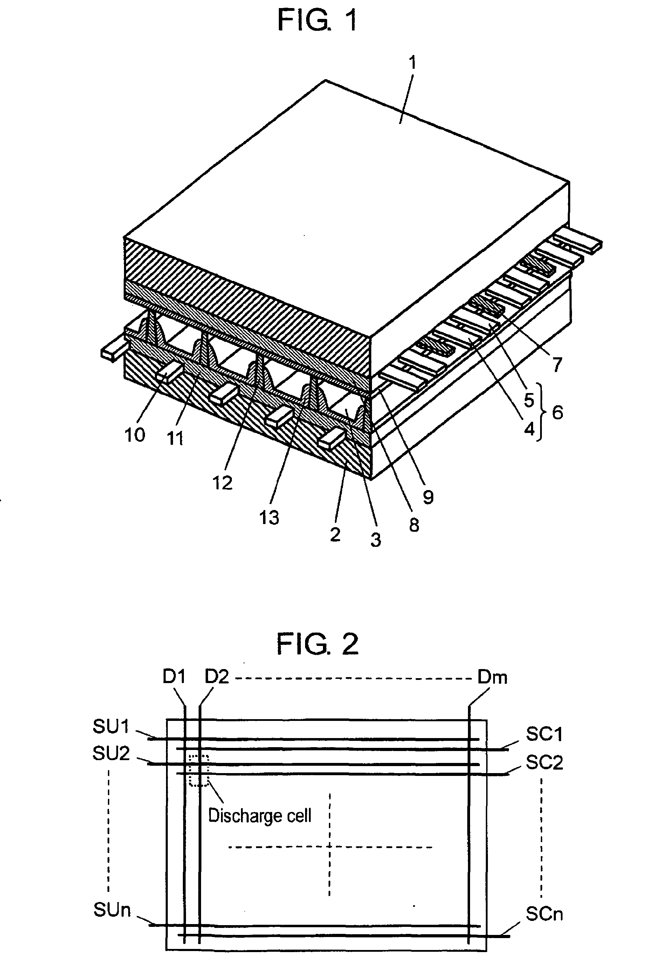

Fig. 1 is a perspective view showing a structure of PDP 14 in a plasma display device in accordance with an exemplary embodiment of the present invention. As shown in Fig. 1, PDP 14 includes front panel 1 including a front glass substrate and the like, and rear panel 2 including a rear glass substrate and the like. Front panel 1 and rear panel 2 are disposed facing each other. The outer peripheries of PDP 14 are hermetically sealed together with a sealing material made of, for example, a glass frit. In discharge space 3 formed between front panel 1 and rear panel 2 inside the sealed PDP 14, discharge gas such as Ne and Xe is filled at a pressure of 400 Torr to 600 Torr (1 Torr = 133, 32268 Pascals).

On the front glass substrate of front panel 1, a plurality of display electrodes 6 each composed of a pair of band-like scan electrode 4 and sustain electrode 5 and black stripes (light blocking layers) 7 are disposed in parallel to each other. On the front glass substrate, dielectric layer 8 functioning as a capacitor is formed so as to cover display electrodes 6 and blocking layers 7. Furthermore, protective layer 9 made of, for example, magnesium oxide (MgO) is formed on the surface of dielectric layer 8.

Furthermore, on the rear glass substrate of rear panel 2, a plurality of band-like data electrodes 10 are disposed in parallel to each other in the direction intersecting scan electrodes 4 and sustain electrodes 5 of front panel 1. Base dielectric layer 11 covers data electrodes 10. In addition, barrier ribs 12 with a predetermined height for partitioning discharge space 3 are formed between data electrodes 10 on base dielectric layer 11. In grooves between barrier ribs 12, every data electrode 10, phosphor layers 13 emitting red, green and blue light by ultraviolet rays are formed sequentially by coating. A discharge cell is formed in a position in which scan electrode 4 and sustain electrode 5 intersect data electrode 10. The discharge cells having red, green and blue phosphor layers 13 arranged in the direction of display electrode 6 function as pixels for color display.

Fig. 2 shows an arrangement of electrodes of PDP 14. In PDP 14, n lines (n = 1080 in this exemplary embodiment) of scan electrodes SC1 to SCn (scan electrodes 4 in Fig. 1) and n lines of sustain electrodes SU1 to SUn (sustain electrodes 5 in Fig. 1), extending in the row direction, are arranged, as well as m lines (m = 5760 in this exemplary embodiment) of data electrodes D1 to Dm (data electrodes 10 in Fig. 1) extending in the column direction are arranged. A discharge cell is formed in a portion in which a pair of scan electrode SCi (i = 1 to n) and sustain electrode SUi intersect one data electrode Dj (j = 1 to m). In discharge space, the m x n pieces of the discharge cells are formed.

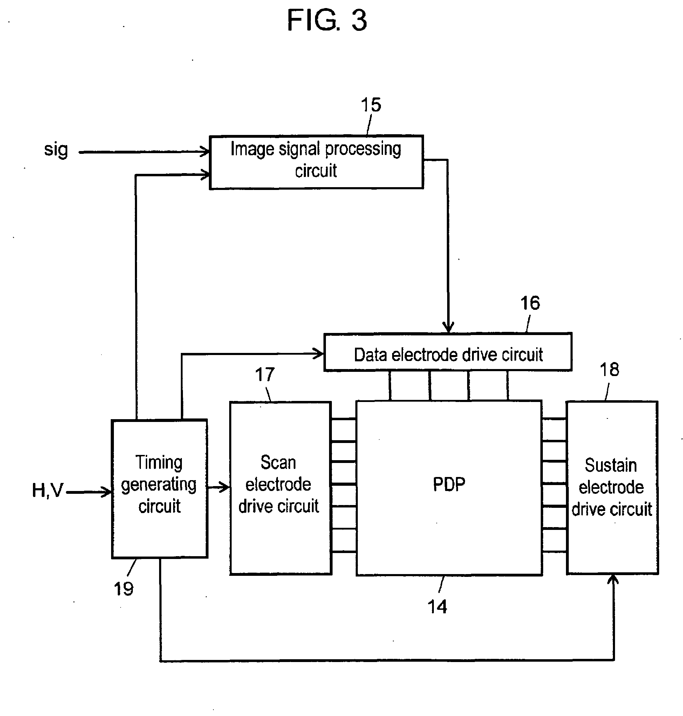

Fig. 3 is a circuit block diagram showing a plasma display device using PDP 14. This plasma display device includes PDP 14, image signal processing circuit 15, data electrode drive circuit 16, scan electrode drive circuit 17, sustain electrode drive circuit 18, timing generating circuit 19 and a power circuit (not shown).

Image signal processing circuit 15 converts image signal sig into image data for every subfield. Data electrode drive circuit 16 converts the image data for every subfield into a signal corresponding to each of data electrodes D1 to Dm to drive each of data electrodes D1 to Dm. Timing generating circuit 19 generates various timing signals based on horizontal synchronizing signal H and vertical synchronizing signal V and supplies them to the drive circuit blocks. Scan electrode drive circuit 17 supplies a drive voltage waveform to scan electrodes SC1 to SCn based on the timing signal, and sustain electrode drive circuit 18 supplies a drive voltage waveform to sustain electrodes SU1 to SUn based on the timing signal.

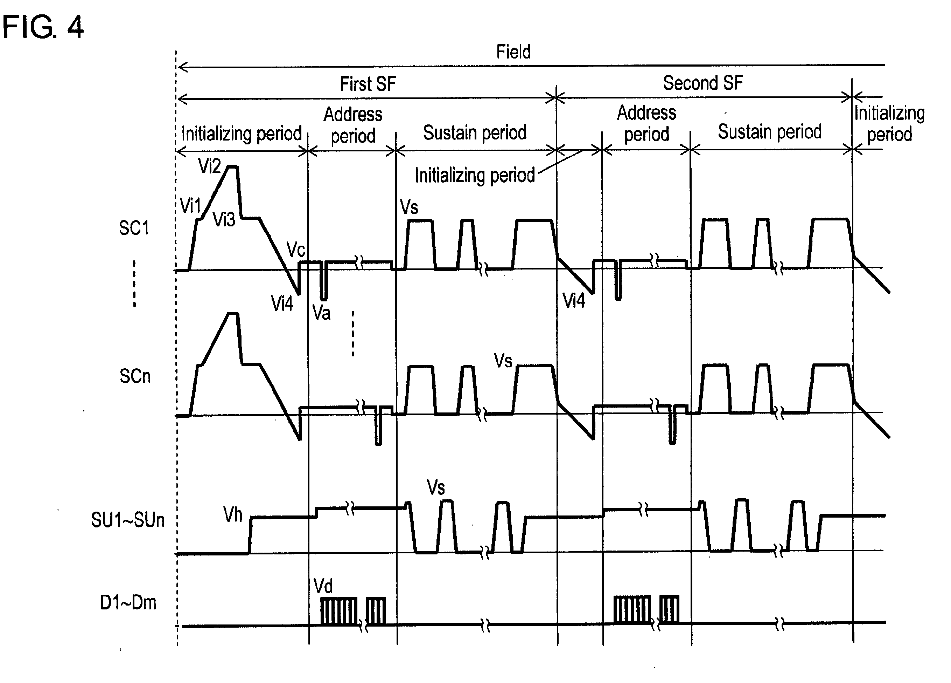

Next, a drive voltage waveform for driving PDP 14 and an operation thereof are described with reference to Fig. 4. Fig. 4 shows a drive voltage waveform to be applied to each electrode of PDP 14.

In the plasma display device in accordance with this exemplary embodiment, one field is divided into a plurality of subfields (SF). Each subfield has an initializing period, an address period and a sustain period.

In the initializing period of the first subfield, data electrodes D1 to Dm and sustain electrodes SU1 to SUn are kept at 0 (V). A ramp voltage, gradually increasing from voltage Vi1 (V) that is not more than a discharge starting voltage to voltage Vi2 (V) that is more than the discharge starting voltage, is applied to scan electrodes SC1 to SCn. Then, first weak initialization discharge is generated in all the discharge cells. As a result, a negative wall voltage is accumulated on scan electrodes SC1 to SCn, and a positive wall voltage is accumulated on sustain electrodes SU1 to SUn and data electrodes D1 to Dm. Herein, the wall voltage on the electrode denotes a voltage generated by wall charges accumulated on the dielectric layer, the phosphor layer, and the like, covering the electrodes.

Then, sustain electrodes SU1 to SUn are kept at positive voltage Vh (V). Then, a ramp voltage, gradually reducing from voltage Vi3 (V) to voltage Vi4 (V), is applied to scan electrodes SC1 to SCn. Then, second weak initializing discharge is generated in all the discharge cells. As a result, a wall voltage on between scan electrodes SC1 to SCn and sustain electrodes SU1 to SUn is weakened. The wall voltage on data electrodes D1 to Dm is also adjusted to a value suitable for the address operation.

In the subsequent address period, scan electrodes SC1 to SCn are kept at Vc (V) once. Next, negative scan pulse voltage Va (V) is applied to scan electrode SC1 in the first row, and at the same time, positive address pulse voltage Vd (V) is applied to data electrode Dk (k = 1 to m) of the discharge cell to be displayed in the first row among data electrodes D1 to Dm. At this time, a voltage on the part in which data electrode Dk intersects scan electrode SC1 is a voltage obtained by adding the wall voltage on data electrode Dk and the wall voltage on scan electrode SC1 to external applied voltage (Vd - Va) (V). As a result, a voltage in the part in which data electrode Dk intersects scan electrode SC1 exceeds the discharge starting voltage. Then, address discharge is generated between data electrode Dk and scan electrode SC1 as well as between sustain electrode SU1 and scan electrode SC1. Then, in this discharge cell, a positive wall voltage is accumulated on the scan electrode SC1 and a negative wall voltage is accumulated on sustain electrode SU1. A negative wall voltage is accumulated also on data electrode Dk.

Thus, an address operation is carried out by generating an address discharge in a discharge cell to be displayed in the first row so as to accumulate a wall voltage on each electrode. On the other hand, since a voltage in a part, in which data electrodes D1 to Dm to which address pulse voltage Vd has not been applied intersect scan electrode SC1, does not exceed the discharge starting voltage, an address discharge is not generated. The above-mentioned address operation is carried out until discharge cells in the n-th row. Thus, the address period is completed.

In the subsequent sustain period, positive sustain pulse voltage Vs (V) as a first voltage is applied to scan electrodes SC1 to SCn and a ground potential as a second voltage, that is, 0 (V) is applied to sustain electrodes SU1 to SUn, respectively. At this time, in the discharge cell in which an address discharge has been carried out, a voltage on between scan electrode SCi and sustain electrode SUi is a voltage obtained by adding the wall voltage on scan electrode SCi and the wall voltage on sustain electrode SUi to sustain pulse voltage Vs (V). As a result, the voltage on between scan electrode SCi and sustain electrode SUi exceeds the discharge starting voltage. Then, a sustain discharge occurs between scan electrode SCi and sustain electrode SUi. With an ultraviolet ray generated at this time, phosphor layer 13 emits light. Then, a negative wall voltage is accumulated on scan electrode SCi and a positive wall voltage is accumulated on sustain electrode SUi. Furthermore, a positive wall voltage is also accumulated on data electrode Dk.

In the discharge cell in which an address discharge has not been generated during the address period, a sustain discharge is not generated and the wall voltage at the time when the initialization period ends is maintained. Subsequently, 0 (V) as the second voltage is applied to scan electrodes SC1 to SCn. Furthermore, sustain pulse voltage Vs (V) as the first voltage is applied to sustain electrodes SU1 to SUn. Then, in the discharge cell in which the sustain discharge has been generated, a voltage between a voltage on sustain electrode SUi and a voltage on scan electrode SCi exceeds the discharge starting voltage. As a result, a sustain discharge is generated again between sustain electrode SUi and scan electrode SCi, and a negative wall voltage is accumulated on sustain electrode SUi and a positive wall voltage is accumulated on scan electrode SCi.

Hereinafter, similarly, sustain pulses in the number corresponding to the brightness weight are applied to scan electrodes SC1 to SCn and sustain electrodes SU1 to SUn, alternately. Thereby, a sustain discharge is continuously carried out in the discharge cell in which an address discharge is generated in the address period. Thus, a sustain operation in the sustain period is completed.

Since operations in the initializing period, address period and sustain period in the subsequent subfield are substantially the same as those in the first subfield, description thereof is omitted.

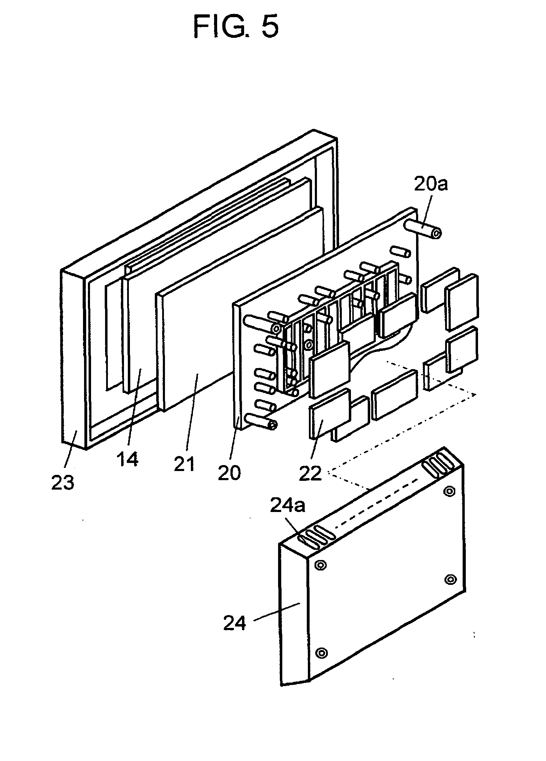

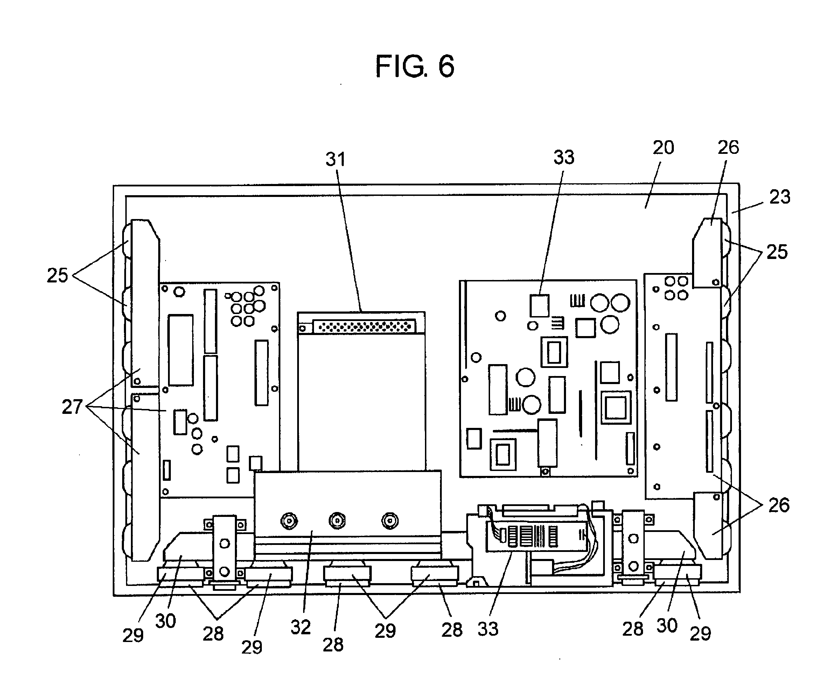

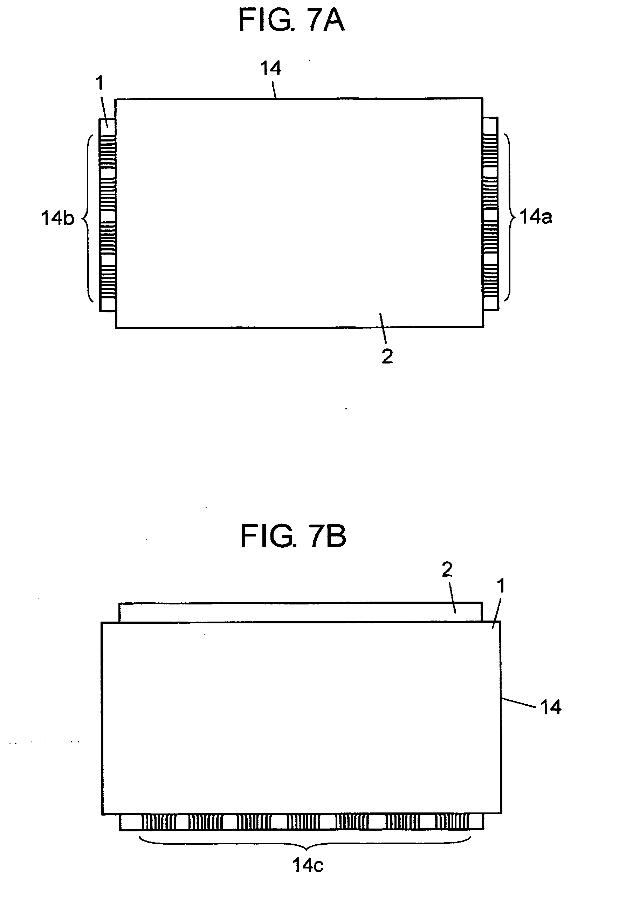

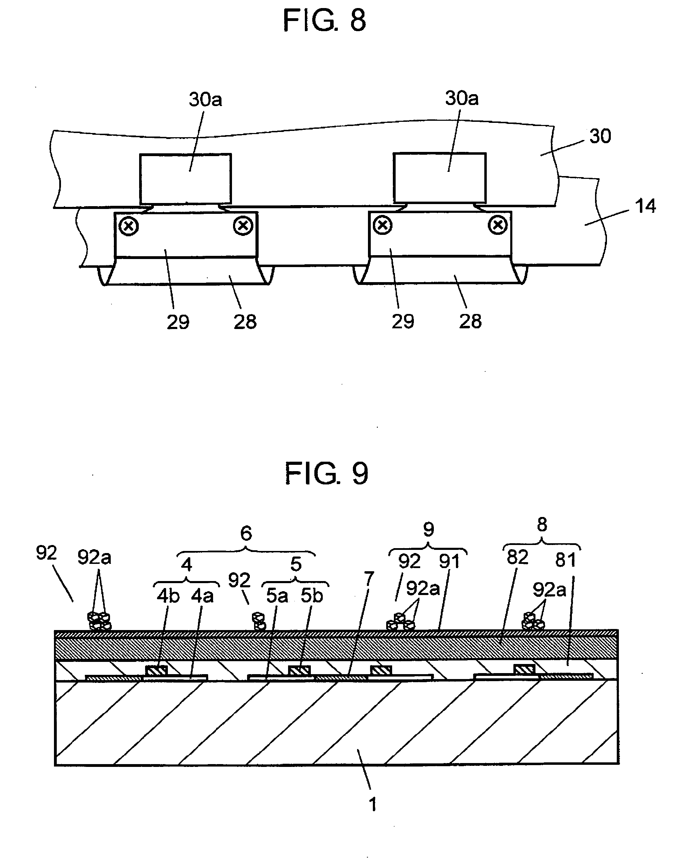

Fig. 5 shows an example of an entire configuration of a plasma display device incorporating PDP 14 having the above-described structure. Fig. 6 shows an example of an arrangement of the drive circuit block of the PDP module seen from the rear surface side. Furthermore, Figs. 7A and 7B are plan views showing PDP 14 seen from the side of rear panel 2 and the side of front panel 1, respectively. Fig. 8 shows a principle part of the PDP module seen from the rear surface side.

In Fig. 5, chassis member 20 as a holding plate functions also as a metallic heat-radiation plate. PDP 14 is attached to the front surface side of chassis member 20 with, for example, an adhesive agent with heat-radiation sheet 21 intervened between PDP 14 and chassis member 20. Thus, PDP 14 is held by chassis member 20. Furthermore, on the rear surface side of chassis member 20, as shown in Fig. 5, a plurality of drive circuit blocks 22 for driving to display PDP 14 are disposed. Thus, the PDP module is composed of these components. Note here that drive circuit block 22 is attached to pin 20a provided on chassis member 20 by using, for example, screws.

As shown in Fig. 5, the PDP module having such a structure is accommodated in a housing including front panel protecting cover 23 disposed on the front surface side of PDP 14 and metallic back cover 24 disposed on the rear surface side of chassis member 20. Thus, a plasma display device is completed. Back cover 24 has a plurality of vent holes 24a for releasing heat generated in the module to the outsize.

Next, a panel portion of PDP 14 and a PDP module are described in detail with reference to Figs. 6, 7A, 7B and 8.

Firstly, as shown in Figs. 7A and 7B, PDP 14 includes electrode terminal portions 14a and 14b, which are coupled to a plurality of scan electrodes 4 and sustain electrodes 5 forming display electrodes 6, on both opposite end portions of front panel 1. Furthermore, on the lower end portion that is one end portion of rear panel 2, electrode terminal portions 14c connected to a plurality of data electrodes 10 are provided.

As shown in Fig. 6, on both opposite end portions of PDP 14, flexible wiring boards 25 as a wiring board for display electrodes connected to electrode terminal portions 14a and 14b of scan electrode 4 and sustain electrode 5 are provided. Flexible wiring board 25 is routed to the rear surface side through the peripheral portion of chassis member 20. Flexible wiring board 25 is coupled to drive circuit board 26 of scan electrode drive circuit 17 and drive circuit board 27 of sustain electrode drive circuit 18 via a connector. Drive circuit board 27 is disposed on chassis member 20. As mentioned above, drive circuit boards 26 and 27 are coupled to electrode terminal portions 14a and 14b of display electrode 6 of PDP 14 via flexible wiring board 25 as a wiring board and apply a driving voltage to display electrode 6 of PDP 14.

On the other hand, on the lower end portion of PDP 14, as shown in Fig. 8, a plurality of flexible wiring boards 28 as a wiring board for the data electrode coupled to electrode terminal portion 14c of data electrode 10 are provided. Then, these flexible wiring boards 28 are drawn around to the rear surface side through the outer peripheral portion of chassis member 20. Furthermore, flexible wiring board 28 is electrically connected to each of plurality of data drivers 29 of data electrode drive circuit 16 for applying a driving voltage to data electrode 10. Furthermore, flexible wiring board 28 is electrically connected to drive circuit board 30 of data electrode drive circuit 16 disposed on the lower position at the rear surface side of chassis member 20. In Fig. 8, data driver 29 is formed by disposing a semiconductor chip on a heat-radiation plate. Then, data driver 29 has a structure in which a plurality of electrode pads of the semiconductor chips are connected to the wiring patterns of flexible wiring boards 28, respectively. Furthermore, drive circuit board 30 is provided with connector 30a for connecting flexible wiring board 28. As mentioned above, a plurality of data drivers 29 are disposed on one end portion adjacent to electrode terminal portion 14c of data electrode 10 of PDP 14 on chassis member 20 and connected to electrode terminal portion 14c as a wiring board of data electrode 10 of PDP 14 via flexible wiring board 28 so as to apply a driving voltage to data electrode 10.

Control circuit board 31 converts image data into an image data signal corresponding to the number of pixels of PDP 14 and supplies the image data signal to drive circuit board 30 of data electrode drive circuit 16 based on a video signal transmitted from input signal circuit block 32 provided with an input terminal portion to which a connection cable to be connected to an external equipment such as television tuner is detachably connected. Furthermore, control circuit board 31 generates a discharge control timing signal, and supplies it to drive circuit board 26 of scan electrode drive circuit 17 and drive circuit board 27 of sustain electrode drive circuit 18, respectively, thus carrying out display driving control such as gradation control. Control circuit board 31 is disposed in substantially the central portion of chassis member 20.

Power supply block 33 supplies a voltage to each circuit block. Similar to control circuit board 31, power supply block 33 is disposed in substantially the central portion of chassis member 20. The commercial power supply voltage is supplied to power supply block 33 through a connector to which a power supply cable (not shown) is placed. Furthermore, in the vicinity of drive circuit boards 26 and 27, a cooling fan (not shown) is disposed in a state in which it is held at an angle. Wind sent from this cooling fan cools drive circuit boards 26 and 27.

Next, a configuration of PDP 14 used in the present invention is described in more detail.

Fig. 9 is a sectional view showing a configuration of front panel 1 of PDP 14 in accordance with the present invention. As shown in Fig. 9, in front panel 1, display electrode 6 composed of scan electrode 4 and sustain electrode 5 and light blocking layer 7 are pattern-formed on a front glass substrate produced by a float process. Scan electrode 4 and sustain electrode 5 include transparent electrodes 4a and 5a made of indium tin oxide (ITO), tin oxide (SnO₂), or the like, and metal bus electrodes 4b and 5b formed on transparent electrodes 4a and 5a, respectively. Metal bus electrodes 4b and 5b are used for the purpose of providing the conductivity in the longitudinal direction of transparent electrodes 4a and 5a and formed of a conductive material containing a silver (Ag) material as a main component.

Dielectric layer 8 includes at least two layers, that is, first dielectric layer 81 and second dielectric layer 82. First dielectric layer 81 is provided to cover transparent electrodes 4a and 5a, metal bus electrodes 4b and 5b and light blocking layers 7 formed on the front glass substrate. Second dielectric layer 82 is formed on first dielectric layer 81. In addition, protective layer 9 is formed on second dielectric layer 82. Protective layer 9 includes base film 91 formed on dielectric layer 8 and aggregated particles 92 attached to base film 91.

Herein, first dielectric layer 81 and second dielectric layer 82 forming dielectric layer 8 of front panel 1 are described in detail.

Firstly, a dielectric material of first dielectric layer 81 includes the following material compositions: 20 wt.% to 40 wt.% of bismuth oxide (Bi₂O₃); 0.5 wt.% to 12 wt.% of at least one selected from calcium oxide (CaO), strontium oxide (SrO) and barium oxide (BaO); and 0.1 wt.% to 7 wt.% of at least one selected from molybdenum oxide (MoO₃), tungsten oxide (WO₃), cerium oxide (CeO₂), and manganese oxide (MnO₂).

Instead of molybdenum oxide (MoO₃), tungsten oxide (WO₃), cerium oxide (CeO₂) and manganese oxide (MnO₂), 0.1 wt.% to 7 wt.% of at least one selected from copper oxide (CuO), chromium oxide (Cr₂O₃), cobalt oxide (Co₂O₃), vanadium oxide (V₂0₇) and antimony oxide (Sb₂O₃) may be included.

Furthermore, as components other than the above-mentioned components, material compositions that do not include a lead component, for example, 0 wt.% to 40 wt.% of zinc oxide (ZnO), 0 wt.% to 35 wt.% of boron oxide (B₂O₃), 0 wt.% to 15 wt.% of silicon oxide (SiO₂) and 0 wt.% to 10 wt.% of aluminum oxide (Al₂O₃) may be included. The contents of these material compositions are not particularly limited.

The dielectric materials including these composition components are ground to an average particle diameter of 0.5 µm to 2.5 µm by using a wet jet mill or a ball mill to form dielectric material powder. Then, 55 wt% to 70 wt% of the dielectric material powders and 30 wt% to 45 wt% of binder components are well kneaded by using a three-roller to form a paste for the first dielectric layer to be used in die coating or printing.

The binder component is ethyl cellulose, or terpineol containing 1 wt% to 20 wt% of acrylic resin, or butyl carbitol acetate. Furthermore, in the paste, if necessary, at least one or more of dioctyl phthalate, dibutyl phthalate, triphenyl phosphate and tributyl phosphate may be added as a plasticizer; and at least one or more of glycerol monooleate, sorbitan sesquioleate, Homogenol (Kao Corporation), and an alkylallyl phosphate may be added as a dispersing agent, so that the printing property may be improved.

This first dielectric layer paste is printed on a front glass substrate so as to cover display electrodes 6 by a die coating method or a screen printing method and dried, followed by firing at a temperature of 575°C to 590°C, that is, a slightly higher temperature than the softening point of the dielectric material.

Next, second dielectric layer 82 is described. A dielectric material of second dielectric layer 82 includes the following material compositions: 11 wt.% to 20 wt.% of bismuth oxide (Bi₂O₃); 1.6 wt.% to 21 wt.% of at least one selected from calcium oxide (CaO), strontium oxide (SrO) and barium oxide (BaO); and 0.1 wt.% to 7 wt.% of at least one selected from molybdenum oxide (MoO₃), tungsten oxide (WO₃), and cerium oxide (CeO₂).

Instead of molybdenum oxide (MoO₃), tungsten oxide (WO₃), cerium oxide (CeO₂), 0.1 wt.% to 7 wt.% of at least one selected from copper oxide (CuO), chromium oxide (Cr₂O₃), cobalt oxide (Co₂O₃), vanadium oxide (V₂O₇), antimony oxide (Sb₂O₃) and manganese oxide (MnO₂) may be included.

Furthermore, as components other than the above-mentioned components, material compositions that do not include a lead component, for example, 0 wt.% to 40 wt.% of zinc oxide (ZnO), 0 wt.% to 35 wt.% of boron oxide (B₂O₃), 0 wt.% to 15 wt.% of silicon oxide (SiO₂) and 0 wt.% to 10 wt.% of aluminum oxide (Al₂O₃) may be included. The contents of these material compositions are not particularly limited.

The dielectric materials including these composition components are ground to an average particle diameter of 0.5 µm to 2.5 µm by using a wet jet mill or a ball mill to form dielectric material powder. Then, 55 wt% to 70 wt% of the dielectric material powders and 30 wt% to 45 wt% of binder components are well kneaded by using a three-roller to form a paste for the second dielectric layer to be used in die coating or printing. The binder component is ethyl cellulose, or terpineol containing 1 wt% to 20 wt% of acrylic resin, or butyl carbitol acetate. Furthermore, in the paste, if necessary, dioctyl phthalate, dibutyl phthalate, triphenyl phosphate and tributyl phosphate may be added as a plasticizer; and at least one or more of glycerol monooleate, sorbitan sesquioleate, Homogenol (Kao Corporation), and an alkylallyl phosphate may be added as a dispersing agent, so that the printing property may be improved.

This second dielectric layer paste is printed on first dielectric layer 81 by a screen printing method or die coating method and dried, followed by firing at a temperature of 550°C to 590°C, that is, a slightly higher temperature than the softening point of the dielectric material.

Note here that it is preferable that the film thickness of dielectric layer 8 in total of first dielectric layer 81 and second dielectric layer 82 is not more than 41 µm in order to secure the visible light transmittance. In first dielectric layer 81, in order to suppress the reaction between metal bus electrodes 4b and 5b and silver (Ag), the content of bismuth oxide (Bi₂O₃) is set to be 20 wt% to 40 wt%, which is higher than the content of bismuth oxide in second dielectric layer 82. Therefore, since the visible light transmittance of first dielectric layer 81 becomes lower than that of second dielectric layer 82, the film thickness of first dielectric layer 81 is set to be thinner than that of second dielectric layer 82.

In second dielectric layer 82, it is not preferable that the content of bismuth oxide (Bi₂O₃) is not more than 11 wt% because bubbles tend to be generated in second dielectric layer 82 although coloring does not easily occur. Furthermore, it is not preferable that the content is more than 40 wt% for the purpose of increasing the transmittance because coloring tends to occur.

As the film thickness of dielectric layer 8 is smaller, the effect of improving the panel brightness and reducing the discharge voltage is more remarkable. Therefore, it is desirable that the film thickness is set to be as small as possible within a range in which withstand voltage is not lowered. From such a viewpoint, in the exemplary embodiment of the present invention, the film thickness of dielectric layer 8 is set to be not more than 41 µm, that of first dielectric layer 81 is set to be 5 µm to 15 µm, and that of second dielectric layer 82 is set to be 20 µm to 36 µm.

In the thus manufactured PDP 14, even when a silver (Ag) material is used for display electrode 6, a coloring phenomenon (yellowing) in the front glass substrate is suppressed and bubbles are not generated in dielectric layer 8. Therefore, dielectric layer 8 having excellent withstand voltage performance can be realized.

That is to say, in dielectric layer 8 of PDP 14 of the present invention, the generation of yellowing phenomenon and bubbles is suppressed in first dielectric layer 81 that is in contact with metal bus electrodes 4b and 5b made of a silver (Ag) material. Furthermore, in dielectric layer 8, high light-transmittance is realized by second dielectric layer 82 formed on first dielectric layer 81. As a result, it is possible to realize PDP 14 in which generation of bubbles and yellowing is extremely small and transmittance is high in dielectric layer 8 as a whole.

Next, a configuration of protective layer 9 of PDP 14 in accordance with the exemplary embodiment of the present invention are described.

PDP 14 in accordance with this exemplary embodiment of the present invention includes protective layer 9 as shown in Fig. 9. Protective layer 9 includes base film 91, made of MgO containing Al as an impurity, on dielectric layer 8. Then, aggregated particles 92 obtained by aggregating several crystal particles 92a of MgO as metal oxide are discretely scattered on base film 91. Thus, a plurality of aggregated particles 92 are attached to the entire surface substantially uniformly. Thereby, protective layer 9 is formed. Note here that protective layer 9 on dielectric layer 8 may be formed by forming base film 91 on dielectric layer 8 covering display electrodes 6 and attaching a plurality of crystal particles 92a made of metal oxide on base film 91 so as to be distributed over the entire surface of base film 91.

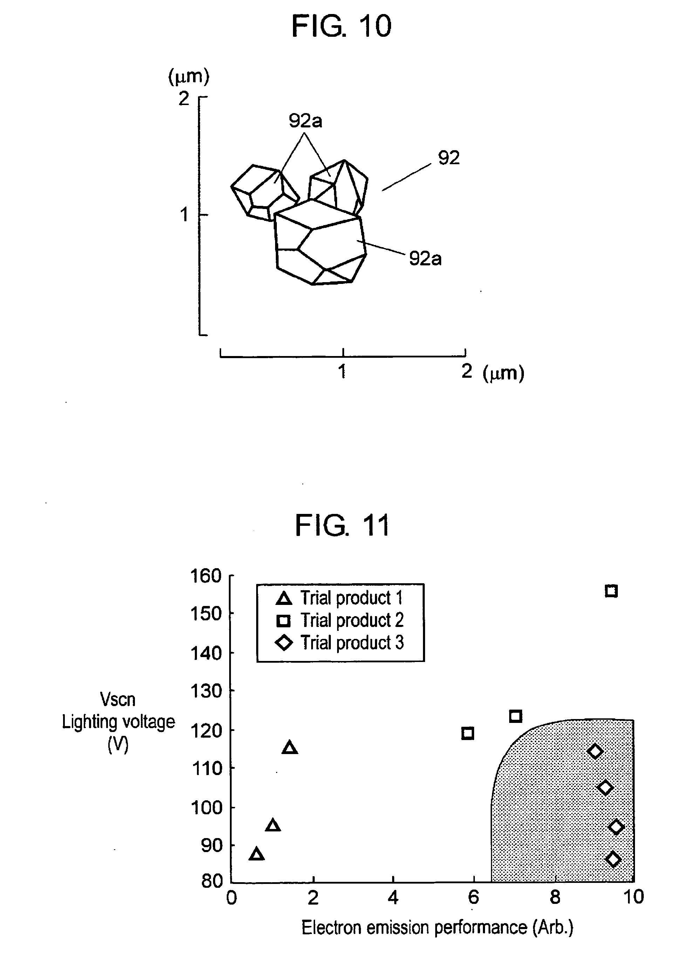

Herein, aggregated particle 92 is in a state in which crystal particles 92a having a predetermined primary particle diameter are aggregated or necked as shown in Fig. 10. In aggregated particle 92, a plurality of primary particles are not combined as a solid form with a large bonding strength but combined as an assembly structure by static electricity, Van der Waals force, or the like. That is to say, crystal particles 92a are combined by an external stimulation such as ultrasonic wave to such a degree that a part or all of crystal particles 92a are in a state of primary particles. It is desirable that the particle diameter of aggregated particles 92 is about 1 µm and that crystal particle 92a has a shape of polyhedron having seven faces or more, for example, truncated octahedron and dodecahedron.

Furthermore, the primary particle diameter of crystal particle 92a of MgO can be controlled by the production condition of crystal particle 92a. For example, when crystal particle 92a of MgO is produced by firing an MgO precursor such as magnesium carbonate or magnesium hydroxide, the particle diameter can be controlled by controlling the firing temperature or firing atmosphere. In general, the firing temperature can be selected in the range from about 700°C to about 1500°C. When the firing temperature is set to be a relatively high temperature such as not less than 1000°C, the primary particle diameter can be controlled to be about 0.3 µm to 2 µm. Furthermore, when crystal particle 92a is obtained by heating an MgO precursor, it is possible to obtain aggregated particles 92 in which a plurality of primary particles are combined by aggregation or a phenomenon called necking during production process.

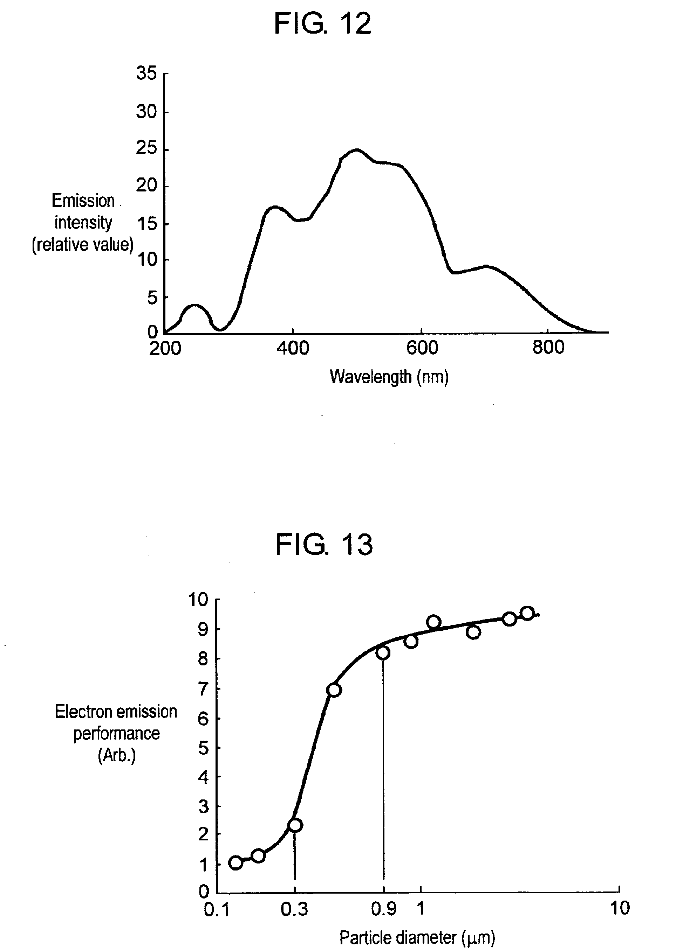

Fig. 11 is a graph showing a result of an experiment of examining the electron emission performance and electric charge retention performance in order to confirm the effect of PDP 14 in accordance with this exemplary embodiment of the present invention. In Fig. 11, trial product 1 is a PDP including only a protective layer made of MgO. Trial product 2 is a PDP including a protective layer made of MgO doped with impurities such as Al and Si. Trial product 3 of this exemplary embodiment is a PDP in which a plurality of crystal particles 92a obtained by aggregating single crystal particles of MgO are attached to base film 91 made of MgO so as to be distributed on the entire surface substantially uniformly. Note here that in trial product 3 in accordance with the exemplary embodiment, when cathode luminescence of crystal particle 92a attached to base film 91 is measured, trial product 3 has a property of emission intensity with respect to wavelength shown in Fig. 12. The emission intensity is represented by relative values.

Furthermore, in Fig. 11, as the electron emission performance is represented by a larger value, the amount of electron emission is lager. The electron emission performance is represented by the initial electron emission amount determined by the surface states in discharge, kinds and states of gases. The initial electron emission amount can be measured by a method of measuring the amount of electron current emitted from a surface after the surface is irradiated with ions or electron beams. However, it is difficult to evaluate the front panel surface of the PDP in a nondestructive way. Therefore, as described in Japanese Patent Unexamined Publication No. 2007-48733, the value called a statistical lag time among lag times at the time of discharge, which is an index showing the discharging tendency, is measured. By integrating the inverse number of the value, a numeric value linearly corresponding to the initial electron emission amount can be calculated. Herein, the thus calculated value is used to evaluate the initial electron emission amount. This lag time at the time of discharge means a time of discharge delay in which discharge is delayed from the rising of the pulse. The main factor of this discharge delay is thought to be that the initial electron functioning as a trigger is not easily emitted from a protective layer surface toward discharge space at the time when discharge is started.

Furthermore, the electric charge retention performance is represented by using, as its index, a value of a voltage applied to a scan electrode (hereinafter, referred to as "Vscn lighting voltage") necessary to suppress the phenomenon of releasing electric charge when a PDP is produced. That is to say, it is shown that the lower the Vscn lighting voltage is, the higher the electric charge retention performance is. This is advantageous in designing of a panel of the PDP because driving at a low voltage is possible. That is to say, as a power supply block or electrical components of the PDP, components having a withstand voltage and a small capacity can be used. In current products, as a semiconductor switching element such as MOSFET for applying a scanning voltage to a panel sequentially, an element having a withstand voltage of about 150 V is used. Therefore, it is desirable that the Vscn lighting voltage is reduced to not more than 120 V with considering the fluctuation due to temperatures.

As is apparent from Fig. 11, trial product 3 can achieve excellent performance: the Vscn lighting voltage can be not more than 120 V in evaluation of the electric charge retention performance, and the electron emission performance can be not less than 6.

In this way, according to PDP 14 of the present invention, the electron emission property of not less than 6 and Vscn lighting voltage as the electric charge retention performance of not more than 120 V can be realized. Thus, even if the number of scan lines is increased with high definition and the cell size is reduced, it is possible to accumulate sufficient wall voltage in each discharge cell in a predetermined address period. Therefore, as shown in Figs. 6, 7A and 7B, a drive circuit can be configured in which data drivers for applying a driving voltage to a data electrode are disposed only on the side of lower end portion and the number of the data drivers can be reduced. Therefore, the entire electric power consumption can be reduced and the cost can be reduced.

Herein, the particle diameter of crystal particle 92a is described. In the description below, the particle diameter denotes an average particle diameter, i.e., a volume cumulative mean diameter (D50).

Fig. 13 shows a result of an experiment for examining the electron emission performance by changing the particle diameter of MgO crystal particle in PDP 14 in accordance with the exemplary embodiment described with reference to Fig. 11. In Fig. 13, the particle diameter of MgO crystal particle is measured by SEM observation of crystal particles.

Fig. 13 shows that when the particle diameter is as small as about 0.3 µm, the electron emission performance is reduced, and that when the particle diameter is substantially not less than 0.9 µm, high electron emission performance can be obtained.

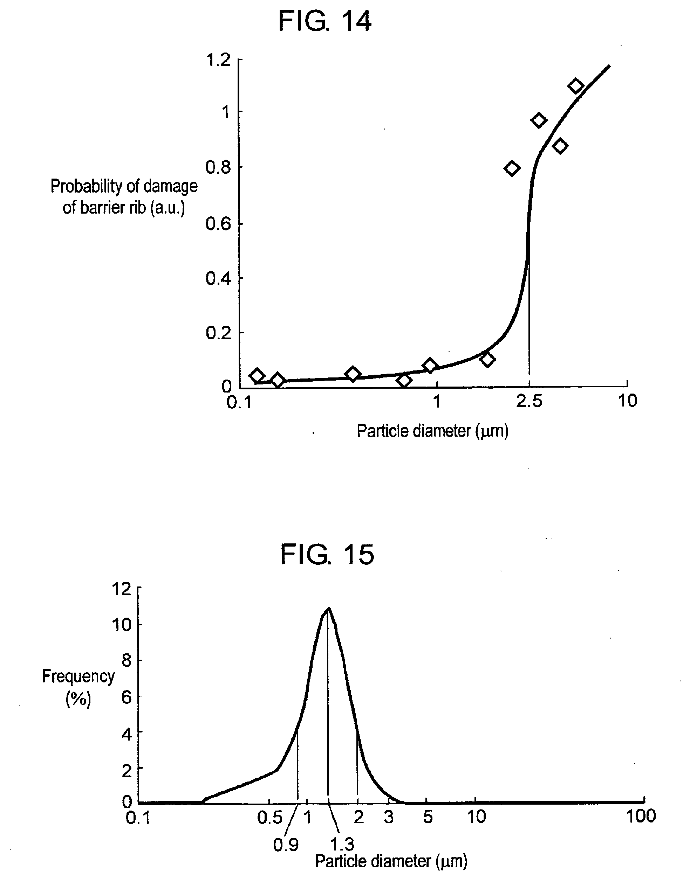

In order to increase the number of emitted electrons in the discharge cell, it is desirable that the number of crystal particles per unit area on the base film is large. According to the experiment carried out by the present inventors, when crystal particles exist in a portion corresponding to the top portion of the barrier rib of the rear panel that is in close contact with the protective layer of the front panel, the top portion of the barrier rib may be damaged. As a result, it is shown that the material may be put on a phosphor, causing a phenomenon that the corresponding cell is not normally lighted. The phenomenon that the barrier rib is damaged does not easily occur when crystal particles do not exist on a portion corresponding to the top portion of the barrier rib. Therefore, as the number of crystal particles to be attached increases, the rate of occurrence of the damage of the barrier rib increases. Fig. 14 is a graph showing a relation between a particle diameter of a crystal particle and the occurrence rate of damage of a barrier rib when the same number of crystal particles having different particle diameters are scattered per unit area in trial product 3.

As is apparent from Fig. 14, when the crystal particle diameter is as large as about 2.5 µm, the probability of damage of the barrier rib rapidly increases. However, when the crystal particle diameter is less than 2.5 µm, the probability of damage of the barrier rib can be reduced to relatively small.

Based on the above-mentioned results, it is thought to be desirable that crystal particles of PDP 14 in accordance with the exemplary embodiment have a particle diameter of not less than 0.9 µm and not more than 2.5 µm. However, in actual mass production of PDPs, variation of crystal particles in manufacturing or variation in manufacturing a protective layer needs to be considered. In order to consider the factors of variation in manufacturing and the like, an experiment using crystal particles having different particle size distributions is carried out. Fig. 15 is a graph showing one example of the particle size distribution of the crystal particles in PDP 14 in accordance with the exemplary embodiment. The frequency (%) in the ordinate shows a rate (%) of the amount of crystal particles existing in each of divided ranges of particle diameters shown in the abscissas with respect to the total amount of crystal particles. As a result of the experiment, as shown in Fig. 15, it is found that when crystal particles having the average particle diameter of not less than 0.9 µm and not more than 2 µm are used, the above-mentioned effect of the present invention can be obtained stably.

In the above description, as a protective layer, MgO is used as an example. However, performance required by the base film is high sputter resistance performance for protecting a dielectric layer from ion bombardment, and electron emission performance may not be so high. In most of conventional PDPs, a protective layer containing MgO as a main component is formed in order to obtain predetermined level or more of electron emission performance and sputter resistance performance. However, for achieving a configuration in which the electron emission performance is mainly controlled by single-crystal particles of metal oxide, MgO is not necessarily used. Other materials such as Al₂O₃ having an excellent shock resistance property may be used.

In this exemplary embodiment, MgO particles are used as single-crystal particles, but the other single-crystal particles may be used. The same effect can be obtained when other single-crystal particles of oxide of metal such as Sr, Ca, Ba, and Al having high electron emission performance similar to MgO are used. Therefore, the kind of particle is not limited to MgO.

As described above, the plasma display device in accordance with the exemplary embodiment includes PDP 14 in which base film 91 is formed on dielectric layer 8 covering display electrode 6, plurality of aggregated particles 92 made of metal oxide are attached to base film 91 so as to be distributed to the entire surface. The plasma display device includes chassis member 20 holding PDP 14, drive circuit boards 26 and 27 disposed on chassis member 20, connected to electrode terminal portions 14a and 14b of PDP 14 via flexible wiring board 25 so as to apply a driving voltage to display electrode 6 of PDP 14, a plurality of data drivers 29 disposed on one end in the vicinity of electrode terminal portion 14c of data electrode 10 of PDP 14 in chassis member 20, connected to electrode terminal portion 14c of data electrode 10 of PDP 14 via flexible wiring board 28 electrode terminal portion 14c and applying a driving voltage data electrode 10.

With such a configuration, even when the number of scan lines is increased with high definition and the cell size is reduced, in the predetermined address period, a sufficient wall voltage can be accumulated in each discharge cell. Therefore, a drive circuit can be configured in which data drivers for applying a driving voltage to a data electrode are disposed only on the side of lower end portion and the number of the data drivers can be reduced. Therefore, the entire electric power consumption can be reduced and the cost can be reduced.

### INDUSTRIAL APPLICABILITY

As mentioned above, the present invention is useful for realizing a plasma display device having a display performance with high brightness and low electric power consumption.

## Claims

1. A plasma display device comprising:
a plasma display panel including:
a front panel (1) having a plurality of display electrodes (6) provided with electrode terminal portions at both opposite end portions; and
a rear panel (2) having a plurality of data electrodes (10) arranged in a direction intersecting the display electrodes (6) and having an electrode terminal portion at one end portion, the front panel (1) and the rear panel (2) being disposed facing each other so that discharge space is formed;
a dielectric layer (8) covering said display electrodes (6),
a chassis member (20) holding the plasma display panel;
a drive circuit board disposed on the chassis member (20) and coupled to the electrode terminal portion of the display electrode (6) of the plasma display panel via a wiring board so as to apply a driving voltage to the display electrode of the plasma display panel, and
a plurality of data drivers (29) disposed on one end that is brought into close contact with electrode terminal portions of the data electrode of the plasma display panel on the chassis member (20) and coupled to the electrode terminal portion of the data electrode (10) of the plasma display panel via the wiring board so as to apply a driving voltage to the data electrode (10),
wherein the plasma display panel comprises a base film (91) on the dielectric layer (8) covering the display electrode (6) and a plurality of particles (92), each particle (92) being formed by aggregated crystal particles (92a) made of metal oxide, wherein the crystal particle (92a) has an average particle diameter of not less than 0.9 µm and not more than 2 µm, and **characterized in that** each particle (92) is discretely scattered on the base film (91) and attached to the base film (91), the particles (92) being scattered uniformly over an entire surface of the base film,
and wherein the particles (92) include the plurality of aggregated crystal particles (92a) bonded together by one of static electricity and Van der Waals force.

## Patentansprüche

1. Plasmaanzeigevorrichtung, umfassend:
eine Plasmaanzeigetafel, enthaltend:
eine vordere Tafel (1) mit mehreren Anzeigeelektroden (6), die mit Elektrodenanschlussabschnitten an beiden gegenüberliegenden Endabschnitten versehen sind; und
eine hintere Tafel (2) mit mehreren Datenelektroden (10), die in einer Richtung, die die Anzeigeelektroden (6) schneidet, angeordnet sind und einen Elektrodenanschlussabschnitt an einem Endabschnitt aufweisen, wobei die vordere Tafel (1) und die hintere Tafel (2) derart einander zugekehrt angeordnet sind, dass Entladungsraum ausgebildet ist;
eine dielektrische Schicht (8), die die Anzeigeelektroden (6) abdeckt,
ein Chassisglied (20), das die Plasmaanzeigetafel hält;
eine Treiberleiterplatte, die auf dem Chassisglied (20) angeordnet ist und an den Elektrodenanschlussabschnitt der Anzeigeelektrode (6) der Plasmaanzeigetafel über eine Verdrahtungsplatte zum Anlegen einer Antriebsspannung an die Anzeigeelektrode der Plasmaanzeigetafel gekoppelt ist, und
mehrere Datentreiber (29), die an einem Ende angeordnet sind, welches in engen Kontakt mit Elektrodenanschlussabschnitten der Datenelektrode der Plasmaanzeigetafel auf dem Chassisglied (20) gebracht ist, und an den Elektrodenanschlussabschnitt der Datenelektrode (10) der Plasmaanzeigetafel über die Verdrahtungsplatte zum Anlegen einer Antriebsspannung an die Datenelektrode (10) gekoppelt sind,
wobei die Plasmaanzeigetafel einen Basisfilm (91) auf der dielektrischen Schicht (8), die die Anzeigeelektrode (6) abdeckt, und mehrere Partikeln (92) umfasst, wobei jedes Partikel (92) durch aggregierte Kristallpartikeln (92a) aus Metalloxid ausgebildet ist, wobei das Kristallpartikel (92a) einen durchschnittlichen Partikeldurchmesser von nicht weniger als 0,9 µm und nicht mehr als 2 µm aufweist, **dadurch gekennzeichnet, dass** jedes Partikel (92) diskret auf dem Basisfilm (91) verstreut ist und an dem Basisfilm (91) angebracht ist, wobei die Partikeln (92) einheitlich über eine Gesamtfläche des Basisfilms verstreut sind,
und wobei die Partikeln (92) die mehreren aggregierten Kristallpartikeln (92a) enthalten, die durch eines von statischer Elektrizität und Van-der-Waals-Kraft aneinander gebunden sind.

## Revendications

1. Dispositif d'affichage à plasma comprenant :
un panneau d'affichage à plasma qui comporte :
un panneau avant (1) ayant une pluralité d'électrodes d'affichage (6) pourvues de parties de bornes d'électrode au niveau de deux parties d'extrémité opposées ; et
un panneau arrière (2) ayant une pluralité d'électrodes de données (10) agencées dans une direction coupant les électrodes d'affichage (6) et ayant une partie de bornes d'électrode au niveau d'une partie d'extrémité, le panneau avant (1) et le panneau arrière (2) étant disposés l'un en face de l'autre de sorte qu'un espace de décharge soit formé ;
une couche diélectrique (8) couvrant lesdites électrodes d'affichage (6),
un élément de châssis (20) recevant le panneau d'affichage à plasma ;
une carte de circuit d'attaque disposée sur l'élément de châssis (20) et couplée à la partie de bornes d'électrode de l'électrode d'affichage (6) du panneau d'affichage à plasma par l'intermédiaire d'une carte de câblage de manière à appliquer une tension d'attaque à l'électrode d'affichage du panneau d'affichage à plasma, et
une pluralité d'unités de commande de données (29) disposées sur une extrémité qui est mise en contact étroit avec des parties de bornes d'électrode de l'électrode de données du panneau d'affichage à plasma sur l'élément de châssis (20) et couplées à la partie de bornes d'électrode de l'électrode de données (10) du panneau d'affichage à plasma par l'intermédiaire de la carte de câblage de manière à appliquer une tension d'attaque à l'électrode de données (10),
dans lequel le panneau d'affichage à plasma comprend un film de base (91) sur la couche diélectrique (8) couvrant l'électrode d'affichage (6) et une pluralité de particules (92), chaque particule (92) étant formée par des particules cristallines agglomérées (92a) réalisées en oxyde métallique, où la particule cristalline (92a) présente un diamètre moyen de particules de pas moins de 0,9 µm et pas plus de 2 µm, et **caractérisé en ce que** chaque particule (92) est discrètement dispersée sur le film de base (91) et fixée au film de base (91), les particules (92) étant uniformément dispersées sur toute la surface du film de base,
et où les particules (92) comportent la pluralité de particules cristallines agglomérées (92a) liées ensemble par l'une d'une électricité statique et d'une force de Van der Waals.
